(19) **Europäisches Patentamt / European Patent Office / Office européen des brevets**

(11) **EP 2 000 780 B1**

(12) **FASCICULE DE BREVET EUROPEEN**

(45) Date de publication et mention
de la délivrance du brevet:
**15.02.2017 Bulletin 2017/07**

(51) Int Cl.:
*G01D 4/00* (2006.01)    *G01R 21/133* (2006.01)

(21) Numéro de dépôt: **08157409.7**

(22) Date de dépôt: **02.06.2008**

(54) **Procédé et système de détection et d'estimation de la consommation des usages électriques des installations d'un souscripteur**

Verfahren und System zur Erfassung und Abschätzung des Stromverbrauchs von elektrischen Anlagen eines Teilnehmers

Method and system for detecting and estimating the electric power consumption of a subscriber's facilities

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **05.06.2007 FR 0703999**

(43) Date de publication de la demande:
**10.12.2008 Bulletin 2008/50**

(73) Titulaire: **Electricité de France
75008 Paris (FR)**

(72) Inventeurs:
- **Charbonnier, Bruno
  75011, PARIS (FR)**
- **D'Urso, Guy
  78800, HOUILLES (FR)**
- **El Guedri, Mabrouka
  92800, PUTEAUX (FR)**

(74) Mandataire: **Cabinet Plasseraud
66 rue de la Chaussée d'Antin
75440 Paris Cedex 09 (FR)**

(56) Documents cités:
EP-A- 1 136 829     WO-A-81/00619
WO-A-97/25625     FR-A- 2 357 907
GB-A- 2 428 806     US-A- 5 483 153
US-B1- 6 937 946

- **JAMES PARIS: 'a framework for non-intrusive load monitoring' MIT PHD DISSERTATION, [en ligne] 01 Février 2006, XP055019335 Extrait de l'Internet:
  <URL:http://dspace.mit.edu/bitstream/handle /1721.1/37081/83290088.pdf?sequence=1> [extrait le 2012-02-14]**
- **C. GREENE: 'Evaluation of Non-Intrusive Monitoring for Condition Based Maintenance Applications on. US Navy Propulsion Plants', [en ligne] 01 Juin 2005, XP055036391 Extrait de l'Internet:
  <URL:http://dspace.mit.edu/bitstream/handle /1721.1/33577/63518079.pdf?sequence=1> [extrait le 2012-08-27]**
- **HART G W: "NONINTRUSIVE APPLIANCE LOAD MONITORING", PROCEEDINGS OF THE IEEE, IEEE. NEW YORK, US, vol. 80, no. 12, 1 December 1992 (1992-12-01), pages 1870-1891, XP000336363, ISSN: 0018-9219, DOI: 10.1109/5.192069**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'énergie électrique est un élément indispensable à l'activité industrielle et économique, mais également dans la vie quotidienne de chacun. Plus précisément, la consommation de cette énergie, dont la production a triplé pendant les trente dernières années en France, se décompose par secteurs où les secteurs les plus importants sont ceux de l'industrie et de l'habitat tertiaire.

La part importante de consommation dans les deux secteurs précités est accompagnée par un intérêt croissant de ces deux familles de clientèle pour une meilleure connaissance de leurs consommations en énergie électrique. Ceci est particulièrement vrai surtout dans le cadre de l'ouverture du marché d'électricité et de la multiplication des usages électriques (de plus en plus d'appareils électroniques, par exemple).

Les producteurs d'électricité sont alors face à de nouveaux défis, que sont l'ouverture du marché d'électricité et la qualité de la puissance fournie.

Un besoin des clients de mieux connaître la consommation de leurs appareils électriques, afin de choisir un ensemble de services proposés, pour améliorer la gestion de leur consommation apparaît. L'énergie électrique, ou toute autre source d'énergie, n'est plus uniquement une source d'énergie. Elle est devenue une source d'information, valorisable tant au niveau client que fournisseur.

L'information extraite de la consommation d'électricité (énergie électrique) est une composante cruciale de toute offre de services aux clients particuliers et professionnels. En effet, elle peut être exploitée pour les renseigner sur leurs consommations par usage, ainsi que dans une optique de maîtrise de la demande de l'énergie (MDE ou DSM : Demand Side Mangement). Cette information est aussi un outil utile au fournisseur pour :

- mieux connaître les profils de ses clients et leur proposer une offre de services ciblés (personnalisés) ;
- améliorer la prévision de la demande et la qualité de la puissance fournie.

Parmi les facteurs déterminants du choix d'un fournisseur en particulier, figurent le prix de l'électricité, les services proposés et la qualité de ces services. Il est manifeste que la qualité des services dépend en particulier de la qualité de l'information extraite de la consommation d'électricité.

La solution la plus fiable consiste à disposer de la consommation de chaque appareil électrique individuellement, ce qui implique toutefois une intrusion chez le client pour instrumenter les appareils de l'installation. En plus de son caractère intrusif, cette solution n'est viable ni économiquement ni techniquement. Ce besoin a donné lieu à de nombreuses études en France et dans d'autres pays, avec pour objectif commun la mise en place d'un outil ayant pour principale vocation :

- d'analyser et de caractériser la consommation globale d'électricité de chaque client ;
- de renseigner les clients sur les consommations de leurs appareils électriques séparément.

Des études récentes exploitent l'analyse non-intrusive de la consommation en électricité dans d'autres applications, en particulier la surveillance des machines et la détection de défauts.

Une méthode viable doit utiliser le minimum d'informations contextuelles et être non-intrusive autant que possible.

Les principales méthodes recensées connues dans la littérature sont exposées ci-après, avec leurs avantages et limites dans le contexte actuel.

Les méthodes précitées sont en général basées sur le principe de décomposition de la courbe de charge, c'est-à-dire des chronogrammes de consommation d'une installation donnée.

Les méthodes de décomposition de la courbe de charge peuvent être distinguées selon leur caractère intrusif lorsque les usages ciblés sont instrumentés avec des capteurs, ou non-intrusif.

Les principales méthodes non-intrusives existantes s'appuient sur les modèles suivants :

(1) le modèle **NILM** (Non-intrusive Load Monitor), développé initialement par des chercheurs du MIT (Massachusetts Institute of Technology) et de l'EPRI (Electric Power Research Institue). Ce modèle est implémenté dans un système portant le nom du modèle, puis un autre système appelé **NIALM** (Non-Intrusive Appliance Load Monitor) en anglais.
(2) le modèle **HELP** (*Heuristic End-Use Load Profiler*) développé par le groupe *Quantum Consulting* en Californie. Ce modèle est implémenté dans un système portant le nom du modèle.
(3) **NALRA** (*Non-intrusive Appliance Load Recognition Algorithm*), développé à l'université de Concordia au Canada;
(4) **RPRA** (*Rule based Pattern Recognition Algorithm*) développé à l'université de Concordia au Canada;
(5) Une méthode de reconnaissance des usages basée sur un algorithme génétique, développé à l'université de Paderborn en Allemagne (2003-2004).

Les deux premiers modèles précités ont abouti à des systèmes commercialisés (ENETICS).

Pour les deux modèles suivants, aucune information n'a été actuellement mise en évidence sur l'éventuelle existence de système utilisé dans le cadre de vente de services. Le dernier modèle est le résultat d'une étude assez récente en Allemagne.

D'un point de vue des techniques utilisées, les approches de décomposition de la courbe de charge peuvent être réparties en trois classes :

• Approches d'ingénierie

Il s'agit d'une approche qui combine des connaissances *a priori* ou hypothèses, relatives à la fréquence d'utilisation des appareils électriques et aux consignes de température pour certains appareils, avec un modèle thermodynamique du bâtiment ou du local étudié. L'inconvénient majeur de cette approche est la nécessité d'exécuter un audit du bâtiment, ce qui est à la fois coûteux et induit une perte de temps.

Les principaux systèmes utilisant cette approche sont :

✔ **HOT2000:** c'est un système développé au CTEC-CANMET (Centre de la Technologie de l'Energie de CANMET) et qui est principalement utilisé dans le secteur résidentiel pour l'estimation de la consommation du chauffage et du chauffe-eau.

✔ **DOE2.1** : développé à l'université de Californie (*Lawrence Berkley Laboratory*) en 1991. Il s'agit d'un simulateur très adapté à la simulation de la consommation globale d'un bâtiment ou d'une agrégation de plusieurs logements ou sites industriels.

• Approches statistiques

Ces approches s'appuient sur la description de chaque usage par un modèle paramétré par des données économiques et climatiques, des caractéristiques physiques de l'usage, des informations sur les occupants et le type de logement. Elles nécessitent également une phase d'apprentissage pour constituer un historique des consommations.

On distingue les trois méthodes suivantes :

■ Analyse conditionnelle de la demande (*Condional demand analysis : CDA*) en anglais
Cette méthode consiste à construire un modèle économétrique du logement du particulier (donnés démographiques et économiques). Elle est principalement utilisée pour l'agrégation des consommations ou le profilage des consommateurs, et non pour l'estimation de la consommation par usage. Ce modèle a été utilisé pour la décomposition de la courbe de charge dans le secteur résidentiel, principalement au Canada.

■ Régression multivariée (*Multivariate Regression Analysis*) en anglais Un modèle de régression en fonction de la température, de l'ensoleillement et d'autres facteurs climatiques est défini. Les paramètres du modèle sont estimés par minimisation d'un critère quadratique. Cette méthode est simple, mais les résultats d'estimation de la consommation par usages sont souvent médiocres. Cette approche est implémentée dans le logiciel PRISM développé à l'université de Princeton.

■ Classification (*Objective classification analysis*) en anglais
Cette méthode combine l'analyse en composantes principales (ACP) et une méthode de regroupement (*clustering* en anglais) pour identifier les jours où la consommation est corrélée au climat, puis de les classifier par jour type dépendant du climat. Cette méthode a été initialement développée pour la prédiction des consommations, en particulier pour les systèmes HVAC (*Heating Ventilation Air-Condtionning*) en anglais (pour les souscripteurs industriels et commerciaux).

• Les approches hybrides

Ce sont des méthodes qui combinent des techniques utilisées dans les deux approches précédentes afin d'améliorer l'estimation des usages. Les principaux modèles utilisés pour la décomposition de la courbe de charge sont :

✔ le modèle **SAE** (*Statistically Adjusted Engineering Model*), 1992;
✔ le modèle **RECAP** (*Residential Energy Consumption Analysis Program*);
✔ le modèle **REEPS** (*Residential End-Use Planning Systems*), EPRI, 1995;
✔ le modèle **EDA** (*End-Use Disaggregation Algorithm : EDA*).

Plusieurs méthodes non-intrusives d'analyse et de décomposition de la courbe de charge électrique ont été proposées durant les deux dernières décennies. Une majeure partie des travaux a été menée au MIT, plus précisément au **LEES** (Laboratory for Electromagnetic and Electronic Systems).

Les travaux sur la courbe de charge aux Etats-Unis ont été initiés par Georges Hart dès 1984 et ont abouti à une méthode de détection et d'estimation des usages électriques dans le secteur résidentiel (Confer notamment G.W. Hart « Residential Energy Monitoring and Computerized Surveillance via Utility Power Plan IEEE Technology and Society Magazine, vol. 6, pp 12-16, 1989). Cette méthode est basée sur les variations de la puissance active et de la puissance réactive, échantillonnées à 1 Hz, à chaque enclenchement ou arrêt d'un appareil électrique. En effet, un événement (enclenchement/déclenchement d'un appareil électrique) est défini comme étant le passage d'un état permanent (niveau de consommation constant) à un autre état permanent.

Les méthodes non-intrusives de l'étude de la courbe de charge, menés au **LEES,** peuvent être classées en deux familles :

- identification des usages fondée sur la signature de consommation (puissance active et puissance réactive) des appareils en régime permanent ;
- identification des usages basée sur la signature de consommation des appareils en régime transitoire.

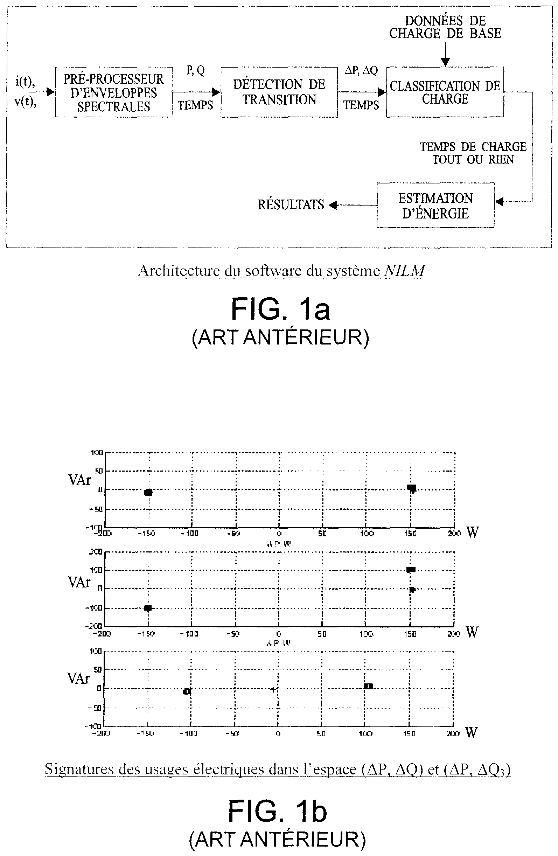

L'approche relative à l'identification des usages électriques en régime permanent est fondée sur la détection des enclenchements et arrêts des différents appareils, au vu des variations de la puissance active et de la puissance réactive. Plus précisément, les courants et tensions des trois phases sont mesurés. Les évènements sont détectés à la fois sur les variations de la puissance active et celles de la puissance réactive. L'architecture de la partie logicielle du système *NILM* (Non-Intrusive Load Monitoring) est illustrée sur la figure 1a.

L'estimation des usages est effectuée en 5 étapes :

- Détection des évènements : il s'agit de détecter les variations de la puissance active $\Delta P$ et de la puissance réactive $\Delta Q$ calculées au moyen d'un pré-processeur à partir des mesures de courants et de tensions. Les évènements sont alors représentés dans l'espace ($\Delta P$, $\Delta Q$) ; on obtient des groupements, désignés clusters en anglais, illustrés par la figure 1b.
  Sur la figure précitée, l'axe des abscisses $\Delta P$ est gradué en Watt W, et l'axe des ordonnées $\Delta Q$ en Volts-Ampères réactifs, VAr. L'entité $\Delta Q3$ désigne la variation de puissance réactive à l'harmonique 3.

- Les groupements de même amplitude et de signes opposés sont regroupés, et correspondent à la signature d'un appareil fonctionnant en « tout ou rien » (mode *on*/*off*).

- Les évènements n'appartenant à aucun groupement sont soit associés à l'un des groupements existants selon un critère de distance ou de maximum de vraisemblance, soit considérés dans une famille des signatures inconnues.

- Chaque groupement est associé à un usage électrique, connaissant sa puissance nominale, et éventuellement d'autres informations. Ces informations sur les amplitudes des usages sont collectées lors d'une phase d'apprentissage. La série temporelle de chaque usage est alors reconstituée.

On peut noter toutefois que la méthode ne prend en compte que les appareils électriques à deux états.

- La dernière étape consiste à estimer l'énergie consommée par chaque usage, connaissant son amplitude et la série des évènements associée.

Cette méthode a été intégrée dans certains produits (NIALMs, NALM et SPEED) commercialisés par la société ENETICS, Inc. VICTOR, N.Y. USA. Cependant, cette méthode présente des inconvénients qui limitent son utilisation à grande échelle ou dans le cadre d'un bouquet de services tels que celui souhaité par les grands distributeurs d'énergie électrique et qui est destiné aux clients résidentiels :

- elle nécessite une phase d'apprentissage sur le site en question ;

- les machines constituées de plusieurs charges (électroménagers) ne sont pas prises en compte, seuls les appareils à deux états sont traités ;

- elle n'est pas adaptée aux secteurs tertiaire et industriel, où l'on observe l'existence d'une plus grande diversité d'appareils, beaucoup plus d'évènements et plusieurs cas d'évènements superposés.

Afin d'étendre la méthode aux secteurs tertiaire et industriel, une nouvelle approche a été introduite. Elle consiste à augmenter la fréquence d'échantillonnage, et à utiliser la signature des appareils en régime transitoire pour identifier ces derniers.

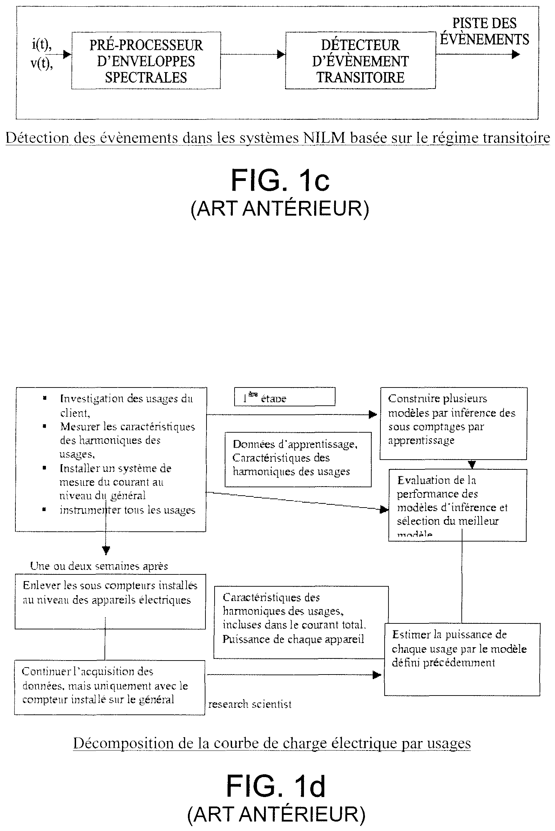

L'identification des usages électriques en régime transitoire en exploitant leurs signatures a initialement été proposée en 1993 (Confer G. W. Hart «Non-intrusive Appliance Load Monitoring » Proceedings of the IEEE, vol. 80, (n° 12) pp 1870-1891, 1992). L'apport de cette méthode consiste à exploiter le lien entre la signature de consommation d'un appareil en régime transitoire à son modèle physique et à la fonction qu'il assure. Le système développé est nommé transient-NILM, et détecte les événements en deux étapes, tel que représenté en figure 1c.

Le premier module du système détermine les enveloppes spectrales, à la fréquence fondamentale et à quelques harmoniques, à partir d'une décomposition spectrale du courant $i(t)$ mesuré à la fréquence d'échantillonnage 8 kHz. Le deuxième module détecte les évènements transitoires (ruptures) sur ces enveloppes. La détection est suivie d'une étape de classification, où un classifieur identifie les formes détectées en les comparant à des formes d'une base de données préalablement construite. L'auteur a également pris en compte le cas de plusieurs machines ayant les mêmes caractéristiques physiques (exemple : machines à induction), mais de dimensions différentes par exemple, et ce en appliquant la procédure à plusieurs échelles temporelles.

On note que la méthode précitée s'appuie sur une base de données de référence, et exploite la signature de consommation de l'usage en régime transitoire uniquement au travers de sa forme, sans toutefois la modéliser.

Une expérimentation a été menée en ce sens sur un navire américain, mettant en oeuvre le modèle NILM pour identifier des usages électriques au moyen d'une analyse d'évènements en régime transitoire (James Paris «A Framework for non-intrusive load monitoring » MIT PhD dissertation, 1 février 2006). A cet effet, une phase d'apprentissage est prévue pour récolter au préalable des données de consommation et constituer une base de données de signatures électriques relatives aux équipements du navire. Par la suite, une décomposition spectrale du courant est mesurée à la fréquence d'échantillonnage de 8 kHz, selon laquelle des évènements transitoires sont détectés. Les formes comprises entre ces évènements sont comparées et identifiées aux formes stockées dans la base de données préétablie de signatures pour déterminer les usages.

Ainsi, les derniers travaux menés dans le domaine de la détection et de l'identification des charges consistent a priori en une approche hybride des deux régimes. Plus précisément, la puissance de l'usage en régime permanent est modélisée par un processus gaussien. Une classification des usages est ensuite réalisée dans l'espace variation de puissance / variation de puissance ($\Delta$P, $\Delta$Q). Un autre classifieur, qui exploite la signature des usages en régime transitoire, permet de pallier aux limites du premier classifieur.

Toutes les méthodes développées et intégrées aux différentes générations du système NILM ont l'inconvénient majeur de nécessiter la mise en oeuvre d'une base de données de référence pour leur phase d'apprentissage. La simplicité des algorithmes développés est à nuancer par la nécessité d'une architecture hardware plus complexe (mesures des courants et tension des trois phases, volume de données à gérer, ...) et la nécessité de l'intervention d'un professionnel pour installer le système. De plus, les systèmes commercialisés sont assez coûteux. Ces facteurs limitent la commercialisation de ces produits à grande échelle, surtout dans le secteur résidentiel. Par contre, ces méthodes ont largement été étudiées dans le secteur tertiaire et le secteur industriel, avec pour objectif l'exploitation du système NILM dans une optique de détection de défauts, de diagnostic et d'identification de systèmes.

D'autres méthodes ont pu être développées plus récemment.

Parmi ces dernières, on citera l'étude réalisée par P. WAGNER « Estimation de la consommation des usages à partir de la courbe de charge d'un particulier - état de l'art », Electricité de France, Note EDF-R&D, HP-1B/05/011/A, Décembre 2005.

Les travaux de recherche à l'université de Paderborn précités ont pour objet de mettre en place un système de reconnaissance des usages électriques et d'estimation des énergies consommées de manière non-intrusive, en exploitant l'unique mesure disponible à la sortie du compteur d'électricité et sans informations a priori. L'exploitation de cette unique mesure permet a priori de réduire le coût du système final.

Les données d'entrée sont la puissance active, échantillonnée à une période entre 1 s et 16 s.

Les usages ciblés par la méthode précitée sont uniquement les usages « fréquents » ou récurrents, tels que le chauffage, le froid alimentaire, l'eau chaude sanitaire. L'algorithme développé consiste en 4 étapes :

- Détecter les évènements, ceux ayant une faible amplitude sont négligés.
- Groupage flou des évènements : les évènements ayant une structure similaire (amplitude, durée entre évènements successifs, ...) sont regroupés dans un même groupement ou « cluster ». Les combinaisons des différents groupements sont des candidats possibles aux différents appareils.
- Générer l'ensemble des candidats potentiels (machines à états) à partir des combinaisons possibles des groupements. Cette étape est réalisée par un algorithme génétique, pour coder et déterminer les différents candidats.
- L'identification des appareils est obtenue en optimisant les séquences des machines d'états candidates. La méthode utilisée pour cette phase d'optimisation est la programmation dynamique.

La reconnaissance des usages électriques est effectuée en s'appuyant sur le résultat de l'algorithme précédent et sur une base de données de référence, contenant des mesures de la puissance active des usages ciblés (pendant environ une semaine).

Cette méthode, assez récente (2003-2004), tente de réduire le coût et supprimer l'intrusion de l'installateur d'un système NILM actuel, en exploitant les données disponibles, à savoir la puissance active seule. Cette simplification de la partie matériel se traduit malheureusement par une grande complexité de l'algorithme de détection et d'estimation des usages. De plus, la méthode nécessite de collecter des données pour la phase d'apprentissage et n'est valable que pour les usages fréquemment utilisés, dits récurrents.

Il est important de préciser que cette étude s'inscrit dans le but d'obtenir un produit qui sera commercialisé et intégré dans les maisons « intelligentes » (smart-homes) en anglais, en exploitant les moyens de communication, en particulier Internet.

Dans les publications de L. Farinaccio, « The Disaggregation of Whole-House Load into the Major End Uses Using a Rule-Based Pattern Recognition Algorithm », Thèse de doctorat, Université de Concordia, Canada, 1999 et de M. L. Marceau et R. Zmeureanu « Non-intrusive load disaggregation computer program to estimate the energy consumption of major-end uses in residential buildings » Energy Conversion and Management, vol. 41, pp 1389-1403, 2000), les auteurs présentent deux méthodes pour estimer les consommations des usages à partir de la puissance active, et éventuellement de la puissance réactive, en se basant sur des méthodes de reconnaissance de forme, basée sur une série de règles d'association. Ces règles permettent de décider de manière séquentielle quel usage est enclenché. Il faut souligner que cette méthode nécessite une phase d'apprentissage d'environ une semaine sur le site considéré, afin de relever les signatures de consommation des usages ciblés. De plus, il faut disposer suffisamment de scénarios d'enclenchements pour estimer certaines caractéristiques de la courbe de charge.

Enfin les travaux menés au CRIEPI (Central Research Institute of Electric Power Industry - Japon), sont fortement orientés vers l'apprentissage chez le client pendant quelques jours. La procédure est décrite sur la figure 1d.

Plus récemment, la demande de brevet CA 2 552 824 publiée le 19 janvier 2007 a divulgué un processus et un système de surveillance de la courbe de charge d'une installation consommant de l'énergie électrique permettant de révéler un comportement frauduleux ou illicite de l'utilisateur, lors de la culture prohibée du cannabis.

Toutefois, dans une telle situation, l'analyse de la courbe de charge de l'installation doit être effectuée à l'insu ou hors d'atteinte de l'utilisateur.

En conséquence, l'appareillage d'analyse est nécessairement placé sur le branchement de l'installation au réseau BT, hors d'atteinte de l'utilisateur.

Un tel agencement ne permet, au mieux, que de discriminer un usage global et le comportement global de l'utilisateur, sans permettre toutefois une analyse fine des usages de ce dernier.

On peut également citer la demande de brevet EP-A-1 136 829 dans laquelle est divulgué un procédé de mesure de la consommation d'un élément électrique utilisant l'échantillonnage à haute fréquence d'un signal électrique représentatif de cet élément électrique. Les demandes WO 97/25625 et US-A-5 483 153 divulguent également un système de surveillance électrique basé sur la seule détection d'un événement électrique transitoire.

La présente invention a pour objet de remédier aux inconvénients et limitations des techniques antérieures, en particulier de supprimer toute base de données relative aux signatures de consommation des développements de l'art antérieur, tout en autorisant une analyse fine des usages des appareils constitutifs de l'installation de tout souscripteur.

Un autre objet de la présente invention est la mise en oeuvre d'un procédé et d'un système de détection et d'estimation de la consommation des usages électriques des installations d'un souscripteur autorisant, grâce à une conception modulaire programmable, une mise en oeuvre par tout client souscripteur.

Le procédé de détection et d'estimation de la consommation des usages électriques des installations d'un compteur, objet de la présente invention, est remarquable en ce qu'il consiste au moins à établir la courbe de consommation électrique générale des installations du souscripteur, et, à effectuer, par segmentation de la courbe de consommation générale des installations du souscripteur et par suivi des évènements de consommation électrique en régime transitoire, la détection du suivi des évènements de consommation électrique et leur consommation correspondante.

Selon un autre aspect remarquable du procédé objet de l'invention, l'étape consistant à établir la courbe de consommation générale des installations du souscripteur inclut au moins l'échantillonnage de la consommation des effluents consommés par les installations du souscripteur, cet échantillonnage intervenant en aval du compteur de consommation d'effluent relié au branchement au réseau général.

Selon un autre aspect remarquable de mise en oeuvre du procédé objet de l'invention, les effluents consommés par les installations du souscripteur comprennent l'un au moins des effluents tels que le gaz, le courant électrique, l'eau.

Le système de détection et d'estimation de la consommation des usages électriques des installations d'un souscripteur, objet de la présente invention, est remarquable en ce qu'il inclut au moins un module de calcul et de mémorisation de la courbe de consommation électrique générale des installations du souscripteur et un module de calcul par segmentation de la courbe de consommation générale des installations du souscripteur et par détection du suivi des évènements de consommation électrique en régime transitoire, de la reconnaissance des usages électriques et leur consommation correspondante.

Selon un autre aspect remarquable, du système objet de la présente invention, le module de calcul et de mémorisation de la courbe de consommation électrique générale des installations du souscripteur comprend au moins un module d'échantillonnage de la consommation des effluents consommés par les installations du souscripteur et un module de mémorisation et de transmission des valeurs échantillonnées vers une plateforme distante de traitement de la reconnaissance des usages électriques et leur consommation correspondante.

Selon un autre aspect remarquable du système objet de la présente invention, le module de transmission des valeurs échantillonnées comporte une ressource de transmission sans fil reliant chacun des modules d'échantillonnage vers une passerelle d'accès réseau et une liaison réseau de la passerelle à la plate-forme distante de traitement.

Le procédé et le système de détection et d'estimation de la consommation des usages électriques des installations d'un souscripteur, objets de la présente invention, trouvent application aux installations de souscripteurs de tous types, notamment installations industrielles, installations domestiques, et peuvent, en particulier, être adaptés aux installations manipulant les effluents les plus divers.

Ils seront mieux compris à la lecture de la description et à l'observation des dessins ci-après dans lesquels, outre les figures 1a à 1d relatives à des solutions de l'art antérieur,

- la figure 2a représente, à titre illustratif, un organigramme général de mise en oeuvre du procédé de détection et d'estimation de la consommation des usages électriques des installations d'un souscripteur, conforme à l'objet de la présente invention ;
- la figure 2b représente un organigramme spécifique des étapes d'échantillonnage d'effluents et de la température extérieure des installations du souscripteur, permettant la mise en oeuvre de la détection et de l'estimation des usages électriques, conformément à l'objet du procédé selon l'invention, représenté en figure 2a ;
- la figure 3 représente, à titre illustratif, un organigramme spécifique des étapes de mise en oeuvre de la segmentation de la courbe de consommation générale des installations du souscripteur ;
- la figure 4a représente, à titre illustratif, un organigramme spécifique des étapes de mise en oeuvre de la détection et du suivi des évènements de consommation ;
- la figure 4b représente, à titre illustratif, un organigramme spécifique des étapes de mise en oeuvre de la discrimination du type d'usage ;
- la figure 5a représente, à titre illustratif, un schéma fonctionnel de l'architecture d'un système de détection et d'estimation de la consommation des usages électriques des installations d'un souscripteur, conforme à l'objet de la présente invention ;
- la figure 5b représente, à titre illustratif, un schéma fonctionnel de la plateforme distante permettant l'exécution de la détection des usages et l'estimation de la consommation des usages, ainsi que l'exécution d'opérations administratives par exemple.

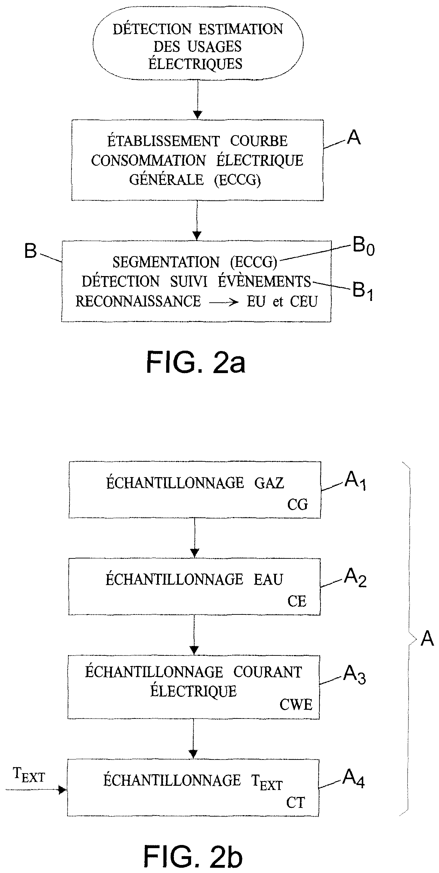

Le procédé de détection et d'estimation de la consommation des usages électriques d'un souscripteur, conforme à l'objet de la présente invention, sera maintenant décrit en liaison avec la figure 2a et les figures suivantes.

En référence à la figure précitée, le procédé objet de l'invention consiste au moins, en une étape A, à établir la courbe de consommation électrique générale des installations du souscripteur. Cette courbe est notée ECCG. sur la figure 2a à l'étape A.

L'étape A est suivie d'une étape B et consistant à effectuer, par segmentation de la courbe de consommation générale des installations du souscripteur, courbe ECCG, et par suivi des événements de consommation électrique en régime transitoire, la reconnaissance des usages électriques et à estimer leur consommations correspondantes.

Sur la figure 2a, l'opération de segmentation est exécutée lors d'une sous étape $B_0$. et le suivi des événements et exécutés lors d'une sous étape $B_1$.

L'opération de reconnaissance des usages électriques et l'estimation de leurs consommations correspondantes est notée :

**Reconnaissance** $\rightarrow$**EU et CEU** où EU désigne les usages électriques et CEU la consommation de ces derniers.

Une description plus détaillée de l'étape A et en particulier de sous étapes de la mise en oeuvre de cette dernière sera maintenant donnée en liaison avec la figure 2b.

D'une manière générale, l'étape A consistant à établir la courbe de consommation générale des installations du souscripteur inclut au moins: l'échantillonnage de la consommation des effluents consommés par les installations du souscripteur. Cet échantillonnage intervient en aval du compteur de consommation d'effluents relié au branchement au réseau général.

Ainsi que représenté de manière non limitative en figure 2b, l'échantillonnage de la consommation des effluents peut comprendre en une étape A1 l'échantillonnage d'un effluent tel que le gaz, en une étape A2 l'échantillonnage de l'eau sanitaire ou industrielle consommée par le souscripteur, en une étape A3, l'échantillonnage du courant électrique par exemple. Sur la figure 2b, les consommations correspondantes sont notées CG, CE, et CWE. On comprend bien sur que les modes et les périodes d'échantillonnage de chacun des effluents précités peuvent être différents afin d'assurer un relevé fidèle des consommations des effluents précités.

En outre, ainsi que représenté sur la même figure 2b, le procédé objet de l'invention peut consister à échantillonner la température extérieure aux installations. Ceci permet de corréler les événements de consommation électrique à l'évolution de la température extérieure aux installations précitées. Sur la figure 2b les valeurs de température extérieure $T_{EXT}$ échantillonnées sont notées CT à l'étape A4 de la figure précitée.

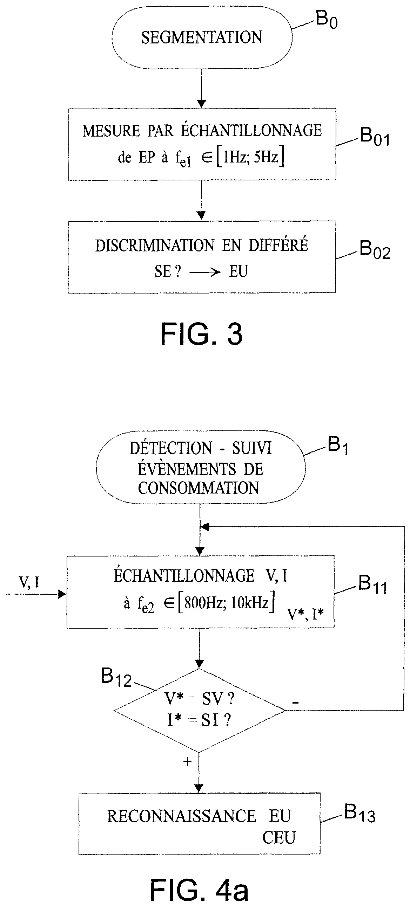

Une description plus détaillée de la mise en oeuvre de l'étape B de la figure 2a sera maintenant donnée en liaison avec la figure 3 et des figures suivantes.

En référence à la figure 3, l'étape de segmentation de la courbe de consommation générale des installations pour la reconnaissance des usages électriques et pour estimer leurs consommations inclut en une étape B01 la mesure par échantillonnage à une fréquence de l'ordre du Herz de la puissance électrique générale relevée par le compteur électrique.

À l'étape B01 de la figure 3 l'opération de mesure par échantillonnage est notée:

$$\text{Mesure par échantillonnage de EP à fe1} \in [1Hz; 5Hz]$$

L'étape B01 est suivie d'une étape B02 de discrimination en différé des usages électriques par identification de la signature électrique à partir, notamment, des consommations échantillonnées d'eau, de gaz et de la température extérieure échantillonnée.

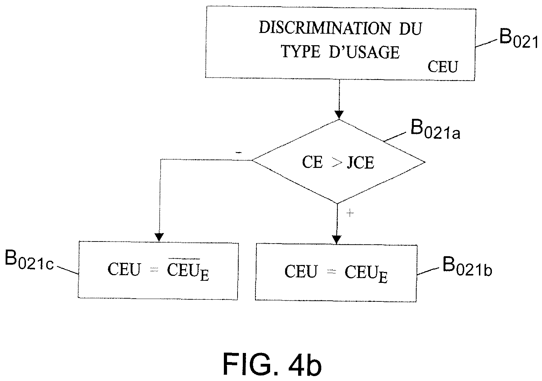

Une description plus détaillée de la sous étape B1 de suivi des événements telle que représentée en figure 2a sera maintenant donnée en liaison avec la figure 4a et la figure 4b.

Ainsi que représenté à la sous étape B11 de la figure 4a, l'étape de détection du suivi des événements de consommation électrique en régime transitoire repose sur un échantillonnage de la tension V et du courant électrique I consommé par l'installation du souscripteur à une fréquence d'échantillonnage fe2 comprise entre 800 Hz et 10 kHz.

À l'étape B11 de la figure 4a précitée, l'opération correspondante est notée :

$$\text{Echantillonnage V, I à fe2} \in [800 \text{ Hz} ; 10 \text{ kHz}]$$

À la même étape B11 de la figure 4a V et I désigne la tension d'alimentation respectivement le courant électrique consommé par l'installation du souscripteur et V* et I* désigne les valeurs échantillonnées correspondantes.

L'étape B11 est suivie d'une étape de test notée B12 consistant à comparer les valeurs échantillonnées V* et I* aux signatures de tension SV respectivement d'intensité du courant SI.

A la sous étape B12 de la figure 4a, les opérations de comparaison correspondante sont notées :

$$V* = SV \, ?$$

$$I* = SI \, ?$$

Lorsque les valeurs échantillonnées de tension et ou de courants ne correspondent pas à la signature respective de tension et de courants, une étape de retour à l'étape B11 est exécutée pour poursuite du processus.

Lorsque, en outre, la discrimination par comparaison réussie des valeurs échantillonnées de tension et de courants vis-à-vis des signatures correspondantes est réalisée, c'est-à-dire sur réponse positive aux comparaisons précitées, alors une reconnaissance des usages électriques dans le contenu peut être effectuée à l'étape B13, suivie du calcul des consommations des usages électriques correspondant reconnus CEU.

On comprend ainsi que l'étape de reconnaissance des usages de consommation électrique est effectuée par une comparaison des signaux électriques et de leurs signatures en régime transitoire, en raison de l'échantillonnage réalisé à la fréquence d'échantillonnage fe2 précitée, laquelle peut être choisie suffisamment élevée pour permettre une exécution sensiblement en temps réel de l'ensemble.

En outre, ainsi que représenté en figure 4b, la discrimination en différé des usages électriques inclut la discrimination du type d'usages d'appareil par corrélation des consommations avec le mode de consommation des effluents.

Ainsi, en référence à la figure 4b précitée, à titre d'exemple non limitatif, la discrimination du type des d'usages peut consister en particulier à comparer la consommation d'eau échantillonnée correspondante à une valeur de seuil de consommation d'eau. Lorsque cette comparaison est positive, on peut conclure, par exemple, lors d'une augmentation soudaine de la consommation d'eau, sous-étape B021b, au lancement d'un appareil domestique tel qu'une machine à laver le linge par exemple, alors que, en réponse négative au test de comparaison à la valeur de seuil précitée, l'on considère en une sous-étape B021c, en l'absence de variations importantes de consommation d'eau, que cet appareil, pour une puissance électrique appelée comparable, constitue par exemple un sèche-linge ou autre.

En conséquence aux sous-étapes B021b et B021c la consommation des usages électriques correspond à un usage électrique accompagné d'eau noté CEUE respectivement à un usage électrique non accompagné d'eau noté $\overline{CEUE}$.

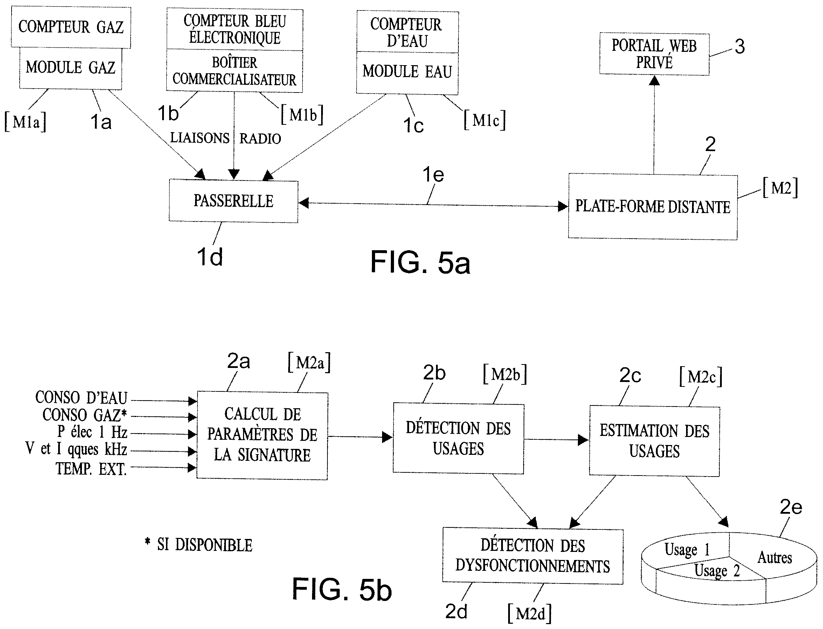

Une description plus détaillée d'un système de détection et d'estimation de la consommation des usages électriques des installations d'un souscripteur, conforme à l'objet de la présente invention, sera maintenant donnée en liaison avec la figure 5a et la figure 5b.

En référence à la figure 5b, on indique que le système objet de l'invention inclut au moins des ressources de calcul et de mémorisation de la courbe de consommation électrique générale des installations du souscripteur. Sur la figure 5b les ressources précitées sont notées 1a, 1b, 1c. En outre, les ressources précitées sont notées MODULE GAZ, MODULE EAU, MODULE ELECTRICITE ou BOITIER COMMERCIALISATEUR. On comprend, en effet, que les modules précités sont installés chez le souscripteur au niveau des installations de ce dernier.

En outre, le système objet de l'invention, comporte des ressources de calcul référencées 2, les ressources de calcul précitées opérant par segmentation de la courbe ECCG de consommation générale par suivi des événements de consommation électrique en régime transitoire, pour exécuter la reconnaissance des usages électriques et leurs consommations correspondantes.

Ainsi qu'on l'a représenté en outre en figure 5a, on comprend que les ressources de calcul et de mémorisation de la courbe de consommation électrique générale des installations du souscripteur comprennent des circuits d'échantillonnage de la consommation des effluents consommés par les installations du souscripteur, ces circuits étant contenus dans les modules 1a, 1b, 1c. En outre le système objet de l'invention comprend, dans les ressources de calcul, des circuits de mémorisation des valeurs échantillonnées de la consommation des effluents consommés et de transmission des valeurs échantillonnées précitées vers une plate-forme distante de traitement de la reconnaissance des usages électriques et leurs consommations correspondantes.

Sur la figure 5a les circuits de mémorisation des valeurs échantillonnées précitées ne sont pas représentés, les ressources de transmission des valeurs échantillonnées précitées vers la plate-forme distante 2 étant représentées par les flèches reliant chacun des modules 1a, 1b, 1c à une passerelle 1d, laquelle est elle-même reliée à la plate-forme distante 2 formant les ressources de calcul par segmentation de la courbe de consommation générale des installations ECCG. La plate-forme distante précitée permet également d'effectuer la reconnaissance des usages électriques et leurs consommations correspondantes.

À l'observation de la figure 5a, on comprend que les modules d'échantillonnage de la consommation des effluents consommés par l'installation du souscripteur sont placés au voisinage des compteurs d'effluents correspondants côté installation précité.

En référence à la même figure 5a, on indique que le système de transmission des valeurs échantillonnées peut comporter avantageusement une ressource de transmission sans fil, reliant chacun des modules 1a, 1b, 1c à la passerelle 1d, ainsi qu'une liaison réseau 1e de la passerelle 1d à la plate-forme distante de traitement 2.

À titre d'exemple non limitatif, on indique que la liaison réseau de la passerelle à la plate-forme distante de traitement peut être constituée par une liaison de type ADSL ou GPRS.

Dans un mode de mise en oeuvre préférentiel non limitatif, la plate-forme distante de traitement 2 peut être reliée à un portail Web 3 permettant tout accès contrôlé du souscripteur au résultat de consommation des usages électriques de ses installations.

La notion d'accès contrôlé recouvre en particulier les critères habituels d'identification du souscripteur à partir d'un code d'identification et toute procédure de sécurisation d'accès pouvant inclure l'authentification et la non répudiation du souscripteur.

Ainsi qu'on l'a en outre représenté en figure 5b, la plate-forme distante 2 peut comprendre avantageusement un module 2a de calcul de paramètres de la signature recevant les valeurs échantillonnées de consommation d'eau CONSO D'EAU, de consommation de gaz CONSO GAZ, de puissance électrique échantillonnée à 1 Hz, de tension V et de courant électrique consommé I. En outre, le module 2a peut recevoir la valeur échantillonnée de la température extérieure aux installations.

La plate-forme distante 2 peut en outre comporter un module 2b de détection des usages de consommation électrique. Ce module est également associé à un module 2c d'estimation de la consommation des usages électriques.

De préférence, ainsi que représenté également en figure 5b, les deux modules précités peuvent avantageusement être associés à un module 2d de détection des dysfonctionnements.

Enfin, ainsi que représenté sur la figure 5b, le module 2c peut être associé à une base de données de la consommation des usages électriques contenant des éléments de données de facturation, lesquelles peuvent être consultées par le seul souscripteur habilité par l'intermédiaire du portail Web privé 3.

L'invention couvre également un produit le programme d'ordinateur comportant une suite d'instructions exécutables par un ordinateur ou par un système dédié de détection et d'estimation de la consommation des usages électriques des installations d'un souscripteur.

Ce produit le programme d'ordinateur est remarquable en ce qu'il comporte au moins un module de programmes d'ordinateur implanté au niveau des installations du souscripteur et permettant d'exécuter le calcul, la mémorisation et la transmission de valeurs échantillonnées de la consommation d'effluents vers une plate-forme distante de traitement pour des effluents, tels que précédemment décrits dans la description, en particulier l'énergie électrique, le gaz, l'eau sanitaire par exemple.

Sur la figure 5a, on comprend ainsi que le produit le programme d'ordinateur peut par exemple avantageusement être constitué par des modules de programmes notés respectivement [M1a], [M1b], [M1c], chacun de ces modules étant bien entendu installé séparément au niveau des modules physiques module 1a, 1b, 1c.

On comprend ainsi que chaque module de programme est installé de façon à échantillonner la consommation d'un des effluents au niveau d'un compteur d'effluent correspondant.

De même, en référence à la figure 5a, et à la figure 5b, on indique que le produit de programme, objet de l'invention, comporte en outre un module de programme d'ordinateur noté [M2], implanté au niveau de la plate-forme distante 2 de traitement.

Le module de programmes d'ordinateur [M2] peut-être constitué soit par un module de programme unique, soit au contraire, ainsi que représenté en figure 5b, par une pluralité de modules de programmes notés respectivement [M2a], [M2b], [M2c], [M2d]. Les différents modules de programmes précités permettent lors de l'exécution des instructions de ces derniers l'exécution de la reconnaissance des usages électriques et le calcul de leurs consommations correspondantes telle que décrite précédemment dans la description.

## Revendications

1. Procédé de détection et d'estimation de la consommation des usages électriques des installations d'un souscripteur, **caractérisé en ce qu'**il consiste au moins à :

   - établir (A) la courbe de consommation électrique générale des installations du souscripteur au moyen d'un échantillonnage ($A_1$, $A_2$) de la consommation d'effluents consommé par les installations du souscripteur, ledit échantillonnage intervenant en aval du compteur de consommation d'effluent relié au branchement au réseau général ;
   - effectuer, par segmentation ($B_0$) de la courbe de consommation générale électrique des installations du souscripteur pour la reconnaissance des usages électriques et estimer leur consommation correspondante incluant :

       ◦ la mesure ($B_{01}$), par échantillonnage à une fréquence de l'ordre du hertz, de la puissance électrique générale relevée par le compteur électrique ;
       ◦ la discrimination ($B_{02}$) en différé des usages électriques par identification de la signature électrique, à partir en outre des consommations échantillonnées d'effluents ;

   et par suivi ($B_1$) des évènements de consommation électrique en régime transitoire reposant sur un échantillonnage ($B_{11}$) de la tension et du courant électrique à une fréquence d'échantillonnage comprise entre 800 Hz et 10 kHz,
   la reconnaissance des usages électriques et estimer leur consommation correspondante.

2. Procédé selon la revendication 1, **caractérisé en ce que** lesdits effluents consommés par les installations du souscripteur comprennent l'un au moins des effluents tels que le gaz, le courant électrique, l'eau.

3. Procédé selon l'une des revendications 1 ou 2, **caractérisé en ce que** celui-ci consiste en outre à échantillonner ($A_4$) la température extérieure aux installations, ce qui permet de corréler les événements de consommation électrique à l'évolution de la température extérieure aux installations.

4. Procédé selon l'une des revendications 1 et 3, **caractérisé en ce que** l'étape de reconnaissance des usages de consommation électrique consiste à effectuer une comparaison ($B_{12}$) des signaux électriques et de leur signature en régime transitoire, ce qui permet une exécution sensiblement en temps réel.

5. Procédé selon la revendication 1 ou la revendication 4 lorsqu'elle dépend de la revendication 1, **caractérisé en ce que** la discrimination en différé des usages électriques inclut la discrimination du type d'usage d'appareil par corrélation des consommations avec le mode de consommation des effluents.

6. Système de détection et d'estimation de la consommation des usages électriques des installations d'un souscripteur, **caractérisé en ce qu'**il inclut au moins :

   - des moyens de calcul et de mémorisation (1a,1b,1c) de la courbe de consommation électrique générale des installations du souscripteur, lesdits moyens de calcul et de mémorisation de la courbe de consommation électrique générale des installations du souscripteur comprennent :
   - des moyens d'échantillonnage de la consommation des effluents consommés par les installations du souscripteur ;
   - des moyens de mémorisation des valeurs échantillonnées de la consommation des effluents consommés et de transmission des dites valeurs échantillonnées vers une plate-forme distante de traitement de la reconnaissance des usages électriques et leur consommation correspondante, et
   - des moyens de calcul, par segmentation de la courbe de consommation électrique générale des installations du souscripteur pour la reconnaissance des usages électriques et estimer leur consommation correspondante incluant :

     ○ des moyens de mesure ($B_{01}$), par échantillonnage à une fréquence de l'ordre du hertz, de la puissance électrique générale relevée par le compteur électrique ;
     ○ des moyens de calcul de la discrimination ($B_{02}$) en différé des usages électriques par identification de la signature électrique, à partir en outre des consommations échantillonnées d' effluents ;

   et par détection du suivi des évènements de consommation électrique en régime transitoire reposant sur un échantillonnage ($B_{11}$) de la tension et du courant électrique à une fréquence d'échantillonnage comprise entre 800 Hz et 10 kHz, de la reconnaissance des usages électriques et leur consommation correspondante.

7. Système selon la revendication 6, **caractérisé en ce que** lesdits moyens d'échantillonnage de la consommation des effluents consommés sont placés au voisinage des compteurs d'effluent correspondant côté installation du souscripteur.

8. Système selon la revendication 6 ou 7, **caractérisé en ce que** lesdits moyens de transmission des valeurs échantillonnées comportent :

   - des moyens de transmission sans fil reliant chacun des moyens d'échantillonnage vers une passerelle d'accès réseau (1d) ;
   - une liaison réseau (1e) de la passerelle à ladite plate-forme distante de traitement.

9. Système selon l'une des revendications 6 à 8, **caractérisé en ce que** ladite plate-forme distante de traitement est reliée à un portail WEB privé (3) permettant tout accès contrôlé dudit souscripteur aux résultats de consommation des usages électriques de ses installations.

10. Produit programme d'ordinateur comportant une suite d'instructions exécutables par un ordinateur ou par un système dédié de détection et d'estimation de la consommation des usagers électriques des installations d'un souscripteur, **caractérisé en ce que** ledit programme d'ordinateur comporte au moins un module de programme d'ordinateur implanté au niveau desdites installations et permettant d'exécuter le calcul, la mémorisation et la transmission de valeurs échantillonnées de la consommation d'effluents vers une plate-forme distante de traitement, pour des effluents tels que l'énergie électrique, le gaz, l'eau sanitaire.

11. Produit programme d'ordinateur selon la revendication 10, **caractérisé en ce que** chaque module de programme est installé de façon à échantillonner la consommation d'un des effluents au niveau d'un compteur d'effluent.

12. Produit programme d'ordinateur selon l'une des revendications 10 ou 11, **caractérisé en ce que** celui-ci comporte en outre un module de programme d'ordinateur implanté au niveau de ladite plate-forme distante de traitement et permettant lors de l'exécution des instructions dudit module de programme d'ordinateur l'exécution de la reconnaissance des usages électriques et le calcul de leur consommation correspondante.

## Patentansprüche

1. Verfahren zum Erfassen und Abschätzen des Verbrauchs der Stromnutzungen der Anlagen eines Teilnehmers, **dadurch gekennzeichnet, dass** es mindestens aus Folgendem besteht:

   - Ermitteln (A) der allgemeinen Stromverbrauchskurve der Anlagen des Teilnehmers mittels einer Abtastung ($A_1$, $A_2$) des Verbrauchs von Flüssen, der von den Anlagen des Teilnehmers verbraucht wird, wobei die Abtastung stromabwärts des Flussverbrauchzählers, der mit dem Anschluss an das Hauptnetz verbunden ist, eingreift,
   - Ausführen durch Segmentieren ($B_0$) der allgemeinen Stromverbrauchskurve der Anlagen des Teilnehmers zur Erforschung der Stromnutzungen und Abschätzen ihres entsprechenden Verbrauchs, darunter:

     ◦ Messung ($B_{01}$) durch Abtasten mit einer Frequenz in der Größenordnung von Hertz der allgemeinen elektrischen Leistung, die von dem Stromzähler erhoben wird,
     ◦ zeitversetzte Unterscheidung ($B_{02}$) der Stromnutzungen durch Identifikation der elektrischen Signatur ausgehend außerdem von den Verbräuchen abgetasteter Flüsse,

   und durch Überwachung ($B_1$) von Stromverbrauchsereignissen im Übergangsbetrieb beruhend auf einer Abtastung ($B_{11}$) der Spannung und des elektrischen Stroms mit einer Abtastfrequenz zwischen 800 Hz und 10 kHz, Erforschen der elektrischen Nutzungen und Abschätzen ihres entsprechenden Verbrauchs.

2. Verfahren nach Anspruch 1, **dadurch gekennzeichnet, dass** die Flüsse, die von den Anlagen des Teilnehmers verbraucht werden, mindestens einen der Flüsse wie zum Beispiel Gas, elektrischer Strom, Wasser umfassen.

3. Verfahren nach einem der Ansprüche 1 oder 2, **dadurch gekennzeichnet, dass** es darin besteht, außerdem die Temperatur außerhalb der Anlagen abzutasten ($A_4$), was es erlaubt, die Ereignisse des Stromverbrauchs mit der Entwicklung der Temperatur außerhalb der Anlagen zu korrelieren.

4. Verfahren nach einem der Ansprüche 1 und 3, **dadurch gekennzeichnet, dass** der Schritt des Erforschens der Nutzungen von Stromverbrauch darin besteht, einen Vergleich ($B_{12}$) der elektrischen Signale und ihre Signatur im Übergangsbereich auszuführen, was eine Ausführung im Wesentlichen in Echtzeit erlaubt.

5. Verfahren nach Anspruch 1 oder Anspruch 4, wenn er von Anspruch 1 abhängt, **dadurch gekennzeichnet, dass** die zeitversetzte Unterscheidung der Stromnutzungen die Unterscheidung des Gerätnutzungstyps durch Korrelation der Verbräuche mit dem Verbrauchsmodus der Flüsse aufweist.

6. System zum Erfassen und Abschätzen des Verbrauchs der Stromnutzungen der Anlagen eines Teilnehmers, **dadurch gekennzeichnet, dass** es mindestens Folgendes aufweist:

   - Mittel zum Berechnen und Speichern (1a, 1b, 1c) der allgemeinen Stromverbrauchskurve der Anlagen des Teilnehmers, wobei die Mittel zum Berechnen und Speichern der allgemeinen Stromverbrauchskurve der Anlagen des Teilnehmers Folgendes umfassen:
   - Mittel zum Abtasten des Verbrauchs der Flüsse, die von den Anlagen des Teilnehmers verbraucht werden,
   - Mittel zum Speichern der abgetasteten Werte des Verbrauchs der verbrauchten Flüsse und Übertragen der abgetasteten Werte zu einer entfernten Plattform zur Verarbeitung der Erforschung der elektrischen Nutzungen und ihres entsprechenden Verbrauchs, und
   - Mittel zum Berechnen durch Segmentieren der allgemeinen Stromverbrauchskurve der Anlagen des Teilnehmers für die Erforschung der elektrischen Nutzungen und Abschätzen ihres entsprechenden Verbrauchs, mit:

     ◦ Mitteln zum Messen ($B_{01}$) durch Abtasten mit einer Frequenz in der Größenordnung von Hertz der allgemeinen elektrischen Leistung, die von dem Stromzähler erhoben wird,
     ° Mitteln zum Berechnen der zeitversetzten Unterscheidung ($B_{02}$) der elektrischen Nutzungen durch Identifikation der elektrischen Signatur ausgehend außerdem von den abgetasteten Verbräuchen von Flüssen,

   und durch Erfassen der Überwachung der Stromverbrauchsereignisse im Übergangsbetrieb beruhend auf einer

Abtastung ($B_{11}$) der Spannung und des elektrischen Stroms mit einer Abtastfrequenz, die zwischen 800 Hz und 10 kHz liegt, der Erforschung der elektrischen Nutzungen und ihres entsprechenden Verbrauchs.

**7.** System nach Anspruch 6, **dadurch gekennzeichnet, dass** die Mittel zum Abtasten des Verbrauchs der verbrauchten Flüsse in der Nähe der Zähler des entsprechenden Flusses auf der Anlagenseite des Teilnehmers platziert sind.

**8.** System nach Anspruch 6 oder 7, **dadurch gekennzeichnet, dass** die Mittel zum Übertragen der abgetasteten Werte Folgendes umfassen:

- drahtlose Übertragungsmittel, die jedes der Abtastmittel mit einem Netzwerk-Zugangs-Gateway (1d) verbinden,
- einen Netzwerkanschluss (1e) des Gateways mit der entfernten Verarbeitungsplattform.

**9.** System nach einem der Ansprüche 6 bis 8, **dadurch gekennzeichnet, dass** die entfernte Verarbeitungsplattform mit einem privaten WEB-Portal (3) verbunden ist, das jeden kontrollierten Zugang des Teilnehmers zu den Verbrauchsresultaten der elektrischen Nutzungen seiner Anlagen erlaubt.

**10.** Computerprogrammprodukt, das eine Abfolge von Anweisungen umfasst, die von einem Computer oder von einem dedizierten Erfassungs- und Abschätzungssystemen des Verbrauchs der elektrischen Verbraucher der Anlagen des Teilnehmers ausführbar sind, **dadurch gekennzeichnet, dass** das Computerprogramm mindestens ein Computerprogrammmodul umfasst, das im Bereich der Anlagen eingerichtet ist und das Ausführen der Berechnung, der Speicherung und der Übertragung der abgetasteten Werte des Verbrauchs von Flüssen zu einer entfernten Verarbeitungsplattform für Flüsse, wie zum Beispiel elektrische Energie, Gas, Leitungswasser, erlaubt.

**11.** Computerprogrammprodukt nach Anspruch 10, **dadurch gekennzeichnet, dass** jedes Programmmodul derart installiert ist, dass es den Verbrauch eines der Flüsse im Bereich eines Flusszählers abtastet.

**12.** Computerprogrammprodukt nach einem der Ansprüche 10 oder 11, **dadurch gekennzeichnet, dass** es außerdem ein Computerprogrammmodul umfasst, das im Bereich der entfernten Verarbeitungsplattform eingerichtet ist und bei der Ausführung der Anweisungen des Computerprogrammmoduls das Ausführen der Erforschung der elektrischen Nutzungen und der Berechnung ihres entsprechenden Verbrauchs erlaubt.

**Claims**

**1.** Method for detecting and estimating the consumption of the electric uses of the facilities of a subscriber, **characterised in that** said method comprises at least:

- establishing (A) the curve of overall electricity consumption of the facilities of the subscriber through a sampling ($A_1$, $A_2$) of the consumption of effluents consumed by the facilities of the subscriber, said sampling being carried out downstream of the effluent consumption meter connected to the connection to the general network;
- carrying out, via segmentation ($B_0$) of the curve of overall electricity consumption of the facilities of the subscriber for the recognition of the electric uses and estimating their corresponding consumption, including:

  ∘ the measurement ($B_{01}$) of the overall electric power measured by the electricity meter, via sampling at a frequency of the order of one hertz;
  ∘ the delayed discrimination ($B_{02}$) of the electric uses via identification of the electric signature, furthermore through the sampled consumption of effluents;

and via monitoring ($B_1$) of the electricity consumption events in transient regime based on a sampling ($B_{11}$) of the voltage and of the electric current at a sampling frequency between 800 Hz and 10 kHz, the recognition of the electric uses and estimating their corresponding consumption.

**2.** Method according to claim 1, **characterised in that** said effluents consumed by the facilities of the subscriber comprise at least one of the effluents such as gas, electric current and water.

**3.** Method according to one of claims 1 and 2, **characterised in that** said method further comprises sampling ($A_4$) the temperature outside of the facilities, which allows the electricity consumption events to be correlated with the change in the temperature outside the facilities.

4. Method according to one of claims 1 and 3, **characterised in that** the step of recognition of the electricity consumption uses comprises carrying out a comparison ($B_{12}$) of the electric signals and of their signature in transient regime signature, which allows substantially real-time execution.

5. Method according to claim 1 or claim 4 when said claim is dependent on claim 1, **characterised in that** the delayed discrimination of the electric uses includes the discrimination of the type of apparatus use via correlation of the consumptions with the mode of consumption of the effluents.

6. System for detecting and estimating the consumption of the electric uses of the facilities of a subscriber, **characterised in that** said system includes at least:

   - means for calculating and memorising (1a, 1b, 1c) the curve of overall electricity consumption of the facilities of the subscriber, said means for calculating and memorising the curve of overall electricity consumption of the facilities of the subscriber comprise:
   - means for sampling the consumption of the effluents consumed by the facilities of the subscriber;
   - means for memorising sampled values of the consumption of the effluents consumed and transmitting said sampled values to a remote platform for processing the recognition of the electric uses and their corresponding consumption, and
   - means for calculating, via segmentation of the curve of overall electricity consumption of the facilities of the subscriber for the recognition of the electric uses and to estimate their corresponding consumption, including:

      ◦ means for measuring ($B_{01}$) the overall electric power measured by the electricity meter, via sampling at a frequency of the order of one hertz;
      ◦ means for calculating the delayed discrimination ($B_{02}$) of the electric uses via identification of the electric signature, furthermore based on the sampled consumption of effluents;

   and via detection of the monitoring of the electricity consumption events in transient regime based on a sampling ($B_{11}$) of the voltage and of the electric current at a sampling frequency between 800 Hz and 10 kHz, the recognition of the electric uses and their corresponding consumption.

7. System according to claim 6, **characterised in that** said means for sampling the consumption of the effluents consumed are placed near the meters of corresponding effluent at a facility of the subscriber.

8. System according to claim 6 or 7, **characterised in that** said means for transmitting the sampled values comprise:

   - wireless transmission means connecting each of the sampling means to a network access gateway (1d);
   - a network link (1e) from the gateway to said remote processing platform.

9. System according to one of claims 6 to 8, **characterised in that** said remote processing platform is connected to a private WEB portal (3) allowing any controlled access by said subscriber to the consumption results of the electric uses of their facilities.

10. Computer program product comprising a series of instructions that can be executed by a computer or by a dedicated system for detection and estimation of the consumption of the electric users of the facilities of a subscriber, **characterised in that** said computer program comprises at least one computer program module installed in said facilities and allowing the calculation, the memorisation and the transmission of sampled values of the consumption of effluents to a remote processing platform to be carried out for effluents such as electric energy, gas, domestic water.

11. Computer program product according to claim 10, **characterised in that** each program module is installed in such a way as to sample the consumption of one of the effluents at an effluent meter.

12. Computer program product according to one of claims 10 and 11, **characterised in that** said product further comprises a computer program module installed in said remote processing platform and allowing, during the execution of the instructions of said computer program module, the execution of the recognition of the electric uses and the calculation of their corresponding consumption.

Architecture du software du système *NILM*

# FIG. 1a
## (ART ANTÉRIEUR)

Signatures des usages électriques dans l'espace $(\Delta P, \Delta Q)$ et $(\Delta P, \Delta Q_3)$

# FIG. 1b
## (ART ANTÉRIEUR)

EP 2 000 780 B1

| i(t), v(t), | PRÉ-PROCESSEUR D'ENVELOPPES SPECTRALES | → | DÉTECTEUR D'ÉVÈNEMENT TRANSITOIRE | PISTE DES ÉVÈNEMENTS → |

Détection des évènements dans les systèmes NILM basée sur le régime transitoire

# FIG. 1c
## (ART ANTÉRIEUR)

- Investigation des usages du client,
- Mesurer les caractéristiques des harmoniques des usages,
- Installer un système de mesure du courant au niveau du général
- instrumenter tous les usages

1ère étape

Données d'apprentissage, Caractéristiques des harmoniques des usages

Construire plusieurs modèles par inférence des sous comptages par apprentissage

Evaluation de la performance des modèles d'inférence et sélection du meilleur modèle

Une ou deux semaines après

Enlever les sous compteurs installés au niveau des appareils électriques

Caractéristiques des harmoniques des usages, incluses dans le courant total. Puissance de chaque appareil

Estimer la puissance de chaque usage par le modèle défini précédemment

Continuer l'acquisition des données, mais uniquement avec le compteur installé sur le général

research scientist

Décomposition de la courbe de charge électrique par usages

# FIG. 1d
## (ART ANTÉRIEUR)

16

DÉTECTION ESTIMATION
DES USAGES
ÉLECTRIQUES

ÉTABLISSEMENT COURBE
CONSOMMATION ÉLECTRIQUE
GÉNÉRALE (ECCG) — A

B — SEGMENTATION (ECCG) — $B_0$
DÉTECTION SUIVI ÉVÈNEMENTS — $B_1$
RECONNAISSANCE ——> EU et CEU

# FIG. 2a

ÉCHANTILLONNAGE GAZ
CG — $A_1$

ÉCHANTILLONNAGE EAU
CE — $A_2$

ÉCHANTILLONNAGE COURANT
ÉLECTRIQUE
CWE — $A_3$

$T_{EXT}$ ——> ÉCHANTILLONNAGE $T_{EXT}$
CT — $A_4$

A

# FIG. 2b

$B_0$

SEGMENTATION

MESURE PAR ÉCHANTILLONNAGE
de EP à $f_{e1} \in [1Hz; 5Hz]$ —$B_{01}$

DISCRIMINATION EN DIFFÉRÉ
SE ? $\longrightarrow$ EU —$B_{02}$

## FIG. 3

DÉTECTION - SUIVI
ÉVÈNEMENTS DE
CONSOMMATION —$B_1$

V, I →

ÉCHANTILLONNAGE V, I
à $f_{e2} \in [800Hz; 10kHz]$ $V*, I*$ —$B_{11}$

$B_{12}$—

V* = SV ?
I* = SI ? —

+

RECONNAISSANCE EU
CEU —$B_{13}$

## FIG. 4a

DISCRIMINATION DU
TYPE D'USAGE
CEU $\quad$ B$_{021}$

B$_{021a}$

CE > JCE

$-$

$+$

B$_{021c}$ $\quad$ CEU = $\overline{CEU_E}$

CEU = CEU$_E$ $\quad$ B$_{021b}$

## FIG. 4b

## FIG. 5a

COMPTEUR GAZ

MODULE GAZ

[M1a]

1a

COMPTEUR BLEU
ÉLECTRONIQUE

BOÎTIER
COMMERCIALISATEUR

[M1b]

1b

COMPTEUR
D'EAU

MODULE EAU

[M1c]

1c

LIAISONS | RADIO

PASSERELLE

1d

1e

PLATE-FORME DISTANTE

[M2]

2

PORTAIL WEB
PRIVÉ

3

## FIG. 5b

CONSO D'EAU
CONSO GAZ*
P élec 1 Hz
V et I qques kHz
TEMP. EXT.

CALCUL DE
PARAMÈTRES DE
LA SIGNATURE

2a    [M2a]

DÉTECTION DES
USAGES

2b    [M2b]

ESTIMATION DES
USAGES

2c    [M2c]

Usage 1
Usage 2
Autres

2e

DÉTECTION DES
DYSFONCTIONNEMENTS

2d    [M2d]

* SI DISPONIBLE

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CA 2552824
- EP 1136829 A
- WO 9725625 A
- US 5483153 A

**Littérature non-brevet citée dans la description**

- **G.W. HART.** Residential Energy Monitoring and Computerized Surveillance via Utility Power Plan. *IEEE Technology and Society Magazine,* 1989, vol. 6, 12-16
- **CONFER G. W. HART.** Non-intrusive Appliance Load Monitoring. *Proceedings of the IEEE,* 1992, vol. 80 (12), 1870-1891
- **JAMES PARIS.** A Framework for non-intrusive load monitoring. *MIT PhD dissertation,* 01 Février 2006
- **P. WAGNER.** Estimation de la consommation des usages à partir de la courbe de charge d'un particulier - état de l'art. *Electricité de France, Note EDF-R&D, HP-1B/05/011/A,* Décembre 2005
- **L. FARINACCIO.** The Disaggregation of Whole-House Load into the Major End Uses Using a Rule-Based Pattern Recognition Algorithm. *Thèse de doctorat,* 1999
- **M. L. MARCEAU ; R. ZMEUREANU.** Non-intrusive load disaggregation computer program to estimate the energy consumption of major-end uses in residential buildings. *Energy Conversion and Management,* 2000, vol. 41, 1389-1403